# EUROPÄISCHE PATENTANMELDUNG

(11) **EP 4 300 604 A1**
(43) Veröffentlichungstag der Anmeldung: **03.01.2024**
(21) Anmeldenummer: 23180279.4
(22) Anmeldetag: 20.06.2023
(51) Int. Cl.: H01L 31/18, H01L 31/0224

(54) **VERFAHREN UND SOLARZELLE**

(30) Priorität: 30.06.2022 DE 102022116340
(71) Anmelder: VON ARDENNE Asset GmbH & Co. KG, 01328 Dresden (DE)
(72) Erfinder: DIMER, Martin, 01309 Dresden (DE); GRAUPNER, Uwe, 01187 Dresden (DE)
(74) Vertreter: Viering, Jentschura & Partner mbB Patent- und Rechtsanwälte

(57) **Zusammenfassung**

Gemäß verschiedenen Ausführungsformen kann ein Verfahren (100) zum Prozessieren einer Solarzellenvorstufe aufweisen: Bilden einer transparenten, elektrisch leitfähigen ersten Schicht (TCO1) über der Solarzellenvorstufe, vorzugsweise wenn die Solarzellenvorstufe transportiert wird; Bilden zumindest einer transparenten, elektrisch leitfähigen zweiten Schicht (TCO2) über der Solarzellenvorstufe, vorzugsweise in körperlichem Kontakt mit der ersten Schicht (TCO1) und/oder wenn die Solarzellenvorstufe transportiert wird, wovon eine zweite Schicht (TCO2) zwischen dem Substrat und der ersten Schicht (TCO1) angeordnet ist und mehr Indium als Zink aufweist; wobei die erste Schicht (TCO1) zumindest Indium, Zink und Sauerstoff aufweist; wobei die zweite Schicht (TCO2) Sauerstoff und einen größeren Anteil von Indium als die erste Schicht (TCO1) aufweist.

## Beschreibung

Verschiedene Ausführungsbeispiele betreffen ein Verfahren und eine Solarzelle.

Seit der Entwicklung und Kommerzialisierung der Solarzelle zur Energiegewinnung steht zwar medienwirksam häufig deren Wirkungsgrad als zentraler Optimierungsparameter im Vordergrund. Allerdings spielen für den Markt auch andere Parameter eine sehr relevante Rolle, darunter Herstellungskosten und Haltbarkeit. Seither wurden verschiedene Architekturen entwickelt, um das Verhältnis aus Nutzen und Kosten zu optimieren. Eine dieser Architekturen verwendet zur Aufnahme des erzeugten Stroms eine sogenannte transparente, leitfähige Oxidschicht (TCO). Dabei wird die TCO-Schicht auf einen selektive Kontaktschicht aus dotiertem amorphem Silizium (a-Si) abgeschieden. Auf die TCO-Schicht wird gewöhnlich ein metallisches Gitter zum Sammeln der Ladungsträger gedruckt. Die dotierten amorphen Silizium-Schichten haben einen zu hohen Widerstand, um die im Silizium generierten Ladungsträger zu dem metallischen Gitter abzuleiten. Die sehr viel höhere Leitfähigkeit der TCO-Schicht ermöglicht den Ladungsträgertransport zum metallischen Gitter. Diese Architektur kommt beispielsweise in der sogenannten Heteroübergang-Silizium-Technologie (**S**ilicon **H**etero **J**unction-J-Technologie) zum Einsatz, bei der kristallines Silizium, in Form von einem Silzium-Wafer, zwischen mindestens zwei Schichten aus amorphem Silizium liegt.

Herkömmlich basieren diese TCO-Schichten auf Indiumoxid, beispielsweise auf Zinn-dotiertem Indiumoxid (ITO). Generell wird zwar angestrebt, dass die TCO-Schicht die Eigenschaften einer möglichst hohen Transparenz und möglichst hohen elektrischen Leitfähigkeit aufweist. Allerdings sind diese Eigenschaften anschaulich Gegenspieler, so dass es zwischen diesen in der Regel zu einem Kompromiss kommt. Zudem werden die Eigenschaften der TCO-Schicht auf die darunter liegende dotierte a-Si-Schicht und die darauf liegende, meist metallische, Schicht angepasst, beispielsweise so dass diese einen möglichst geringen Kontaktwiderstand zueinander aufweisen, was einen geringen Serienwiderstand der Solarzelle zur Folge hat. Die Anpassung dieser Eigenschaften begünstigt einen hohen Wirkungsgrad der Solarzelle. Eine Herausforderung ist, TCO-Schichten abzuscheiden, die eine sehr hohe Transparenz, einen niedrigen Widerstand und auch geringe Kontaktwiderstände zeigen. Unglücklicherweise sind Indium und damit auch eine darauf basierende TCO-Schicht sehr teuer. Hinzu kommt, dass Indium ein seltenes Element und nur begrenzt verfügbar ist.

Daher ist es ein generelles Bestreben, preiswertere und leichter verfügbare Möglichkeiten zum Bereitstellen einer TCO-Schicht für eine Solarzelle bereitzustellen.

Gemäß verschiedenen Ausführungsformen wurde erkannt, dass Aluminium-dotiertes Zinkoxid (AZO) ein aussichtsreicher Kandidat zur Befriedigung dieses Bestrebens ist. Dabei wurde insbesondere die gefestigte Meinung, dass AZO aufgrund seines höheren spezifischen Widerstands und seiner Neigung, schnell zu altern und dabei den Wirkungsgrad erheblich zu beeinträchtigen, ungeeignet ist, überwunden. Die schnelle Alterung von AZO lässt sich beispielsweise im sogenannten Damp-Heat-Test nachvollziehen, bei dem die Solarzelle erhöhter Temperatur und Feuchtigkeit ausgesetzt wird. Die Alterung drückt sich z.B. in einer signifikanten Erhöhung des spezifischen Widerstandes aus.

In dem Zusammenhang wurde erkannt, dass ein Schichtstapel, bei dem eine Schicht aus AZO dünn mit ITO abgedeckt wird, beispielsweise als Teil eines Schichtstapels aus ITO/AZO/ITO, zu einem Wirkungsgrad der Solarzelle führt, der vergleichbar ist mit ITO als Referenz. Insbesondere lässt sich nachvollziehen, dass eine AZO-Schicht im Damp-Heat-Test weniger oder gar nicht degradiert, wenn sie mit von einer ITO-Schicht abgedeckt (dann auch als Deckschicht bezeichnet) wird.

In dem Zusammenhang wird gemäß verschiedenen Ausführungsformen dem Kostendruck Rechnung getragen, unter dem die Herstellung von Solarzellen steht. Diese Kosten steigen mit der Anzahl der Prozesskammern und auch der Länge der Prozesskammern. Dies begrenzt die Möglichkeiten, die Anzahl unterschiedlicher Schichten eines TCO-Schichtstapels zu vergrößern. Dasselbe gilt für bereits bestehende Sputteranlagen, in denen sich die Herstellung zusätzlicher Schichten nur schwer integrieren lässt, da diese z.B. bei anderen Prozessparametern abgeschieden werden, welche sich von Prozessparametern unterscheiden, für welche die Sputteranlagen ausgelegt worden sind.

Gemäß verschiedenen Ausführungsformen wird ein TCO-Schichtstapel auf Basis von AZO bereitgestellt, beispielsweise für den Einsatz als Vorderkontakt und/oder Rückseitenkontakt einer Solarzelle, der preiswerter zu implementieren ist, beispielsweise ohne dass zusätzliche Prozess- oder Gasseparationskammern installiert werden müssen.

Hierin wird Bezug genommen auf verschiedene Oxide, beispielsweise Indiumzinnoxid (auch als ITO bezeichnet) und mit Aluminium dotiertes Zinkoxid (auch als AZO bezeichnet), welche als transparentes elektrisch leitfähiges Oxid (auch als TCO bezeichnet) eingerichtet sind. Das hierzu Beschriebene kann ebenso für ein transparentes elektrisch leitfähiges Oxid (auch als TCO bezeichnet) gelten, beispielsweise Fluor-Zinn-Oxid (FTO) und/oder Antimon-Zinn-Oxid (ATO) auf.

Es zeigen
- Figur 1: ein Verfahren gemäß verschiedenen Ausführungsformen in einem schematischen Ablaufdiagramm;
- Figur 2, 3 und Figur 4: ein Verfahren gemäß verschiedenen Ausführungsformen in einer schematischen Ansicht;
- Figur 5A und B: jeweils ein Diagramm gemäß verschiedenen Ausführungsformen;
- Figur 6A und B: jeweils eine Vakuumanordnung gemäß verschiedenen Ausführungsformen; und
- Figur 7A und B: jeweils die Beschichtung des Solarzellenvorläufers in verschiedenen Konfigurationen gemäß verschiedenen Ausführungsformen.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Im Folgenden werden verschiedene Beispiele beschrieben, die sich auf hierin Beschriebene und in den Figuren Dargestellte beziehen.

Beispiel 1 ist ein Verfahren zum Prozessieren (z.B. Beschichten und/oder mittels eines Durchlaufverfahrens, z.B. In-line Beschichtung) eines Solarzellenvorläufers (hierin auch als Solarzellenpräkursor, Solarzellenvorstufe, Solarzellenstapel oder Solarzellensubstrat bezeichnet) (z.B. zur Abscheidung einer oder mehr als einer Schicht auf dem Solarzellenvorläufer), das Verfahren aufweisend: Bilden einer transparenten, elektrisch leitfähigen ersten Schicht auf dem Solarzellenvorläufer (beispielsweise in körperlichen Kontakt mit dem Solarzellenvorläufer); Bilden einer oder mehr als einer transparenten, elektrisch leitfähigen zweiten Schicht auf dem Solarzellenvorläufer (beispielsweise in körperlichen Kontakt mit der ersten Schicht und/oder dem Solarzellenvorläufer); wobei die erste Schicht Sauerstoff und Indium (z.B. eine chemische Verbindung aus Indium mit Sauerstoff und vorzugsweise einen ersten Dotanten der chemischen Verbindung aus Indium mit Sauerstoff) aufweist, und wobei die erste Schicht ferner Zink und/oder Aluminium (z.B. eine chemische Verbindung aus Sauerstoff mit Zink und vorzugsweise einen zweiten Dotanten, z.B. das Aluminium, der chemischen Verbindung aus Sauerstoff mit Zink) aufweist; wobei die oder jede zweite Schicht Sauerstoff aufweist und einen größeren Anteil (z.B. eine größere Konzentration) von einem oder mehr als einem aus Indium, Aluminium und/oder Zink und/oder kleineren Gradienten des Anteils aufweist als die erste Schicht.

Beispiel 2 ist ein Verfahren (z.B. gemäß dem Beispiel 1) zum Prozessieren eines Solarzellenvorläufers, das Verfahren aufweisend: Emittieren eines ersten Materialstroms, der Zink und Sauerstoff aufweist, zu dem Solarzellenvorläufer hin; Emittieren eines zweiten Materialstroms, der Indium und Sauerstoff aufweist, zu dem Solarzellenvorläufer hin; wobei das Emittieren des ersten Materialstroms und das Emittieren des zweiten Materialstroms derart erfolgt, dass dadurch ein (z.B. homogenes) Materialgemisch (vereinfacht auch als Gemisch bezeichnet) gebildet wird, mit welchem der Solarzellenvorläufer beschichtet wird, welches transparent und elektrisch leitfähig ist und einen Anteil von Indium aufweist, der (z.B. kontinuierlich) zunimmt oder abnimmt entlang einer Richtung (beispielsweise die Richtung der Schichtdicke) von dem Solarzellenvorläufer weg und/oder entlang einer Strecke von dem Substrat weg (z.B. entlang der Dickenrichtung), die mehr als 5 nm (z.B. als 10 nm, z.B. als 15 nm) ausgedehnt ist, wobei das Materialgemisch beispielsweise zumindest Indium, Zink und Sauerstoff aufweist und/oder eine erste Schicht bereitstellt.

Beispiel 3 ist eine Solarzelle (vorzugsweise hergestellt mittels des Verfahrens gemäß Beispiel 1 oder 2), aufweisend: einen Halbleiter (z.B. als Substrat), vorzugsweise einen Halbleiterübergang bereitstellend; eine transparente, elektrisch leitfähige ersten Schicht über dem Halbleiter (beispielsweise in körperlichen Kontakt mit dem Halbleiter); eine oder mehr als eine transparente, elektrisch leitfähige zweite Schicht über dem Halbleiter (beispielsweise in körperlichen Kontakt mit dem Halbleiter und/oder der ersten Schicht); wobei die erste Schicht Sauerstoff und Indium (z.B. eine chemische Verbindung aus Indium mit Sauerstoff und vorzugsweise einen ersten Dotanten der chemischen Verbindung aus Indium mit Sauerstoff) aufweist, und wobei die erste Schicht Zink und/oder Aluminium (z.B. eine chemische Verbindung aus Sauerstoff mit Zink und vorzugsweise einen zweiten Dotanten, z.B. das Aluminium, der chemischen Verbindung aus Sauerstoff mit Zink) aufweist; wobei die oder jede zweite Schicht Sauerstoff aufweist und einen größeren Anteil von einem oder mehr als einem aus Indium, Aluminium und/oder Zink und/oder kleineren Gradienten des Anteils aufweist als die erste Schicht.

Beispiel 4 ist eines der Beispiele 1 bis 3, wobei ein erster Materialstrom zum Bilden der ersten Schicht und ein zweiter Materialstrom zum Bilden der zweiten Schicht einander durchdringen und/oder demselben Prozessgas (z.B. derselben chemischen Zusammensetzung dessen und/oder demselben Druck dessen) ausgesetzt sind. Dies optimiert die Beschichtungseigenschaften.

Beispiel 5 ist eines der Beispiele 1 bis 4, wobei die zweite Schicht eine chemische Verbindung aus Sauerstoff mit Indium oder Zink und vorzugsweise den ersten Dotanten, z.B. Zinn, der chemischen Verbindung aus Sauerstoff mit Indium aufweist. Dies optimiert die Beschichtungseigenschaften.

Beispiel 6 ist eines der Beispiele 1 bis 5, wobei eine erste Rate (z.B. angegeben als Materialmenge pro Zeit), mit der das Bilden der ersten Schicht erfolgt, größer ist, als eine zweite Rate (z.B. angegeben als Materialmenge pro Zeit), mit der das Bilden der zweiten Schicht erfolgt. Dies optimiert das Verhältnis von Kosten zu Nutzen.

Beispiel 7 ist eines der Beispiele 1 bis 6, wobei die erste Schicht zwischen dem Solarzellenvorläufer und der zweiten Schicht angeordnet ist, oder wobei die zweite Schicht zwischen dem Solarzellenvorläufer und der ersten Schicht angeordnet ist.

Beispiel 8 ist eines der Beispiele 1 bis 7, wobei die erste Schicht und/oder die zweite Schicht in körperlichen Kontakt sind mit einem Halbleiter des Solarzellenvorläufers und/oder einem Oxid des Halbleiters. Dies optimiert die elektrischen Beschichtungseigenschaften.

Beispiel 9 ist eines der Beispiele 1 bis 8, wobei die zweite Schicht eine chemische Verbindung aus Sauerstoff mit einem oder mehr als einem aus Indium, Aluminium und/oder Zink aufweist. Dies optimiert die Beschichtungseigenschaften, z.B. hinsichtlich der elektrischen Leitfähigkeit.

Beispiel 10 ist eines der Beispiele 1 bis 9, wobei die erste Schicht ein homogenes Gemisch aus Indium und Zink oder deren chemischen Verbindungen mit Sauerstoff (d.h. deren Oxid) aufweist. Dies optimiert die Beschichtungseigenschaften, z.B. hinsichtlich der elektrischen Leitfähigkeit.

Beispiel 11 ist eines der Beispiele 1 bis 10, wobei die zweite Schicht frei ist von Zink. Dies optimiert die Beschichtungseigenschaften, z.B. hinsichtlich der optischen Eigenschaften.

Beispiel 12 ist eines der Beispiele 1 bis 11, wobei die zweite Schicht eine größere spezifische Leitfähigkeit aufweist als die erste Schicht. Dies optimiert die Beschichtungseigenschaften, z.B. hinsichtlich der elektrischen Leitfähigkeit.

Beispiel 13 ist eines der Beispiele 1 bis 12, wobei die zweite Schicht einen größeren Transmissionskoeffizienten aufweist als die erste Schicht. Dies optimiert die Beschichtungseigenschaften, z.B. hinsichtlich des Wirkungsgrads.

Beispiel 14 ist eines der Beispiele 1 bis 13, wobei eine Beschichtung (z.B. ein Schichtstapel) des Solarzellenvorläufers, welche die erste Schicht und die zweite Schicht aufweist, vorzugsweise bei einer Wellenlänge von 600 nm, einen Reflexionskoeffizienten von weniger als 1% aufweist. Dies optimiert die Beschichtungseigenschaften, z.B. hinsichtlich des Wirkungsgrads, und/oder lässt sich mittels des Sauerstoffflusses einstellen.

Beispiel 15 ist eines der Beispiele 1 bis 14, wobei die erste Schicht und/oder die zweite Schicht einen ersten Dotanten einer chemischen Verbindung aus Indium mit Sauerstoff aufweisen, wobei der erste Dotant vorzugsweise Zinn und/oder Zinn und/oder Zirkon und/oder Titan und/oder Cer, und/oder Wolfram aufweist, oder daraus (z.B. einer Kombination zwei oder mehr dieser verschiedenen chemischen Elemente) besteht ist. Dies optimiert die Beschichtungseigenschaften, z.B. hinsichtlich der elektrischen Eigenschaften.

Beispiel 16 ist eines der Beispiele 1 bis 15, wobei die zweite Schicht mehr Indium als Zink und/oder mehr Indium als Aluminium aufweist. Dies optimiert die Beschichtungseigenschaften, z.B. hinsichtlich der Lebensdauer.

Beispiel 17 ist eines der Beispiele 1 bis 16, wobei das Bilden der ersten Schicht mittels Zerstäubens eines ersten, vorzugsweise keramischen, Sputtertargets erfolgt und/oder wobei das Bilden der zweiten Schicht mittels Zerstäubens eines zweiten, vorzugsweise keramischen, Sputtertargets erfolgt. Dies optimiert die Beschichtungseigenschaften, z.B. hinsichtlich der Herstellungskosten.

Beispiel 18 ist eines der Beispiele 1 bis 17, wobei die erste Schicht eine größere Schichtdicke (Ausdehnung entlang einer Richtung von dem Solarzellenvorläufer weg) aufweist als die zweite Schicht, wobei beispielsweise die erste Schicht eine Schichtdicke von mindestens der doppelten Schichtdicke der zweiten Schicht und/oder von mehr als ungefähr 50 Nanometer (z.B. ungefähr 80 Nanometer) aufweist. Dies optimiert die Beschichtungseigenschaften, z.B. hinsichtlich des Verhältnisses aus Kosten und Nutzen.

Beispiel 19 ist eines der Beispiele 1 bis 18, wobei die erste Schicht zwischen der zweiten Schicht und dem Solarzellenvorläufer angeordnet ist und/oder wobei die zweite Schicht einen höheren Anteil Indium aufweist als die erste Schicht. Dies optimiert die Beschichtungseigenschaften, z.B. hinsichtlich der Lebensdauer.

Beispiel 20 ist eines der Beispiele 1 bis 19, wobei der Solarzellenvorläufersauf einer Seite, auf welcher die ersten Schicht und/oder zweite Schicht gebildet sind, mit einer transparenten, elektrisch leitfähigen zusätzlichen zweiten Schicht bedeckt ist (wobei vorzugsweise die erste Schicht zwischen der zweiten Schicht und der zusätzlichen zweiten Schicht angeordnet ist und/oder wobei vorzugsweise die zusätzliche zweite Schicht zwischen der ersten Schicht und dem Solarzellenvorläufer angeordnet ist); wobei die zusätzliche zweite Schicht einen größeren Anteil von Indium oder Zink als die erste Schicht aufweist; wobei beispielsweise die zusätzliche zweite Schicht die zweite Schicht oder die erste Schicht körperlich kontaktiert. Dies optimiert die Beschichtungseigenschaften, z.B. hinsichtlich der Haftung und/oder Beeinträchtigung des Solarzellenvorläufers.

Beispiel 21 ist eines der Beispiele 1 bis 20, wobei die zweite Schicht einen kleineren Anteil Zinn und/oder Aluminium aufweist als die erste Schicht und/oder als die zusätzliche zweite Schicht. Dies optimiert die Beschichtungseigenschaften, z.B. hinsichtlich der elektrischen Eigenschaften.

Beispiel 22 ist eines der Beispiele 1 bis 21, wobei der Solarzellenvorläufer bzw. die Solarzelle einen Halbleiterübergang aufweisen.

Beispiel 23 ist eines der Beispiele 1 bis 22, wobei der Halbleiterübergang mehrere Schichten aufweist, die Silizium aufweisen und/oder sich in ihrem Kristallinitätsgrad (Grad der strukturellen Ordnung in einem Festkörper, z.B. angegeben als Anteil von Kristallen) voneinander unterscheiden, und/oder die eine Schicht aus kristallinem Silizium zwischen zwei Schichten aus amorphem Silizium aufweisen. Dies optimiert die Herstellungskosten.

Beispiel 24 ist eines der Beispiele 1 bis 23, wobei die Solarzelle ferner eine Metallisierung aufweist, welche die zweite Schicht (z.B. elektrisch und/oder körperlich) kontaktiert, und/oder welche eine Beschichtung (z.B. einen Schichtstapel) des Solarzellenvorläufers, welche die erste Schicht und die zweite Schicht aufweist, (z.B. elektrisch und/oder körperlich) kontaktiert. Dies optimiert die Beschichtungseigenschaften, z.B. hinsichtlich der elektrischen Kontaktierung.

Beispiel 25 ist Beispiel 24, wobei die Metallisierung mehrere ohmsch miteinander gekoppelte Streifen aufweist und/oder in einen Graben, der in der zweiten Schicht gebildet ist, angeordnet ist. Dies verbessert die elektrischen Eigenschaften.

Beispiel 26 ist eines der Beispiele 1 bis 25, wobei die erste Schicht einen Anteil von Zink aufweist, der über eine Ausdehnung der ersten Schicht kontinuierlich abnimmt (z.B. zu dem Solarzellenvorläufer hin oder davon weg), wobei die Ausdehnung größer ist als 15 nm.

Beispiel 27 ist eines der Beispiele 1 bis 26, wobei das Bilden der ersten Schicht über der Solarzellenvorstufe erfolgt, wenn (z.B. während) die Solarzellenvorstufe transportiert wird; und/oder wobei das Bilden der zweiten Schicht über der Solarzellenvorstufe erfolgt, wenn (z.B. während) die Solarzellenvorstufe transportiert wird.

Beispiel 28 ist eines der Beispiele 1 bis 27, wobei von der einen oder mehr als einen zweiten Schicht zumindest eine zweite Schicht TCO2: zwischen dem Substrat und der ersten Schicht TCO1 angeordnet ist; und/oder mehr Indium als Zink (und/oder als Zinn) aufweist (z.B. anteilig, z.B. in Atomprozent oder Massenprozent angegeben); und/oder im Wesentlichen (d.h. z.B. 50% davon oder mehr, z.B. 75% oder mehr, z.B. 90% oder mehr, z.B. 95% oder mehr, z.B. 100%) aus ITO besteht.

Beispiel 29 ist eines der Beispiele 1 bis 28, wobei die erste Schicht TCO1 Zink und/oder Aluminium, vorzugsweise in einem größeren Verhältnis zu Indium als die zweite Schicht TCO2, aufweist.

Beispiel 30 ist eines der Beispiele 1 bis 29, wobei die eine oder mehr als eine zweite Schicht TCO2 zumindest zwei zweite Schichten TCO2 aufweist, zwischen denen die erste Schicht TCO1 angeordnet ist; wobei die erste Schicht eine größere Dicke aufweist als die oder jede zweite Schicht der zwei Schichten, z.B. als eine zusätzliche zweite Schicht der zwei zweiten Schichten, wobei beispielsweise die erste Schicht zwischen der zweiten Schicht und der zusätzlichen zweiten Schicht angeordnet ist.

Beispiel 31 ist eines der Beispiele 1 bis 30, wobei von der einen oder mehr als einen zweiten Schicht TCO2 die oder jede zweite Schicht (z.B. jede von zwei zweiten Schichten) mehr Indium als Zink oder als Zinn aufweist (z.B. anteilig, z.B. in Atomprozent oder Massenprozent angegeben), z.B. mehr als doppelt so viel Indium wie Zink aufweist; und/oder wobei von der einen oder mehr als einen zweiten Schicht TCO2 die oder jede zweite Schicht (z.B. jede von zwei zweiten Schichten) mindestens 10 nm aufweist.

Beispiel 32 ist eines der Beispiele 1 bis 31, wobei eine erste Rate (z.B. angegeben als Materialmenge pro Zeit), mit der das Bilden der ersten Schicht (z.B. AZO aufweisend oder daraus bestehend) erfolgt, größer ist, als eine zweite Rate (z.B. angegeben als Materialmenge pro Zeit), mit der das Bilden der zweiten Schicht (z.B. ITO aufweisend oder daraus bestehend) erfolgt, z.B. größer als das Doppelte der zweiten Raten. Dies optimiert das Verhältnis von Kosten zu Nutzen.

Beispiel 33 ist eines der Beispiele 1 bis 32, wobei die oder jede zweite Schicht eine Dicke von mehr als 5 nm (z.B. 10 nm oder 15 nm) oder weniger als eine Dicke der ersten Schicht aufweist; und/oder wobei die zweite Schicht einen Gradienten an Indium aufweist, der von dem Substrat weg abnimmt und/oder über die Dicke von mehr als 5 nm (z.B. 10 nm oder 15 nm) ausgedehnt ist.

Hierin wird Bezug genommen auf verschiedene Angaben über den Anteil eines chemischen Elements oder Materials an einer Referenz, wobei die Referenz das chemische Element oder Material aufweist. Der Anteil kann angegeben sein oder werden als
- Anteil an der Gesamtmasse (dann auch als Massenanteil bezeichnet, z.B. angegeben als gew%) einer Referenz,
- Anteil an dem Gesamtvolumen (dann auch als Volumenanteil bezeichnet, z.B. angegeben als vol%) der Referenz
- Anteil an der Stoffmenge der Referenz (dann auch als Stoffmengenanteil bezeichnet, z.B. angegeben als at%), oder
- als Konzentration (z.B. angegeben als Atomanzahl pro Volumen, z.B. in at/cm³).

Als Referenz kann beispielsweise der Körper (z.B. das Sputtertarget oder eine Schicht) dienen, welcher das chemische Element oder Material aufweist, oder ein homogenes Materialgemisch dienen, welches das chemische Element oder Material aufweist.

Bezüglich des schichtbildenden Prozesses wird hierin exemplarisch auf das sogenannte Sputtern Bezug genommen. Der Begriff "Sputtern" bezeichnet das Zerstäuben eines Materials (auch als Beschichtungsmaterial oder Targetmaterial bezeichnet) mittels eines Plasmas. Die zerstäubten Bestandteile des Beschichtungsmaterials (z.B. einzelne Atome und/oder Ionen) werden voneinander separiert, bilden dabei einen Materialstrom und können beispielsweise zum Bilden einer Schicht woanders angelagert werden. Das Sputtern kann mittels einer sogenannten Sputtervorrichtung erfolgen, welche ein oder mehr als ein Magnetsystem aufweisen kann (dann auch als Magnetron bezeichnet). Das Beschichtungsmaterial kann mittels eines sogenannten Sputtertargets (kurz auch als Target bezeichnet) bereitgestellt sein, welches beispielsweise rohrförmig (dann auch als Rohrtarget bezeichnet) oder plattenförmig (dann auch als Plattentarget oder Planartarget bezeichnet) sein kann. Zum Erzeugen des Plasmas kann an das Sputtertarget (kurz auch als Target bezeichnet) eine Spannung (auch als Sputterspannung bezeichnet) angelegt werden, so dass das Sputtertarget als Kathode betrieben wird. Auch wenn die Sputterspannung eine Wechselspannung aufweist, wird die Begrifflichkeit der Kathode häufig beibehalten.

Zum Sputtern kann das Sputtertarget in einer Vakuum-Prozessierkammer (vereinfacht auch als Prozessierkammer oder Vakuumkammer bezeichnet) angeordnet sein, so dass das Sputtern in einem Vakuum erfolgen kann. Dazu können die Umgebungsbedingungen (die Prozessparameter) innerhalb der Vakuum-Prozessierkammer (z.B. Prozessdruck, Temperatur, Gaszusammensetzung, usw.) während des Sputterns eingestellt oder geregelt werden. Beispielsweise kann innerhalb der Prozessierkammer ein Arbeitsgas bereitgestellt sein oder werden, welches das plasmabildende Gas oder das plasmabildende Gasgemisch bezeichnet. Die Prozessierkammer kann beispielsweise luftdicht, staubdicht und/oder vakuumdicht eingerichtet sein oder werden, so dass innerhalb der Prozessierkammer eine Gasatmosphäre mit einer vordefinierten Zusammensetzung (auch als Arbeitsatmosphäre bezeichnet) oder einem vordefinierten Druck (auch als Arbeitsdruck oder Prozessdruck bezeichnet) bereitgestellt werden kann (z.B. gemäß einem Sollwert), z.B. ein Vakuum.

Das Plasma kann mittels des Arbeitsgases (auch als plasmabildendes Gas bezeichnet) gebildet werden. Gemäß verschiedenen Ausführungsformen kann das Arbeitsgas ein gasförmiges Material aufweisen, welches reaktionsträge ist, mit anderen Worten welches sich nur an wenigen oder gar keinen chemischen Reaktionen beteiligt. Ein Arbeitsgas kann beispielsweise von dem verwendeten Targetmaterial definiert sein oder werden und an dieses angepasst sein oder werden. Beispielsweise kann ein Arbeitsgas ein Gas oder ein Gasgemisch aufweisen, welches mit dem Targetmaterial nicht zu einem Feststoff reagiert oder diesem gegenüber sogar inert ist. Das Arbeitsgas kann beispielsweise ein Edelgas (z.B. Helium, Neon, Argon, Krypton, Xenon, Radon) oder mehrere Edelgase aufweisen. Wird ein Reaktivgas als Prozessgas oder Bestandteil dessen verwendet, kann das Reaktivgas eine höhere chemische Reaktivität als das Arbeitsgas aufweisen, z.B. bezüglich des Targetmaterials. Mit anderen Worten kann das zerstäubte Targetmaterial zusammen mit dem Reaktivgas (wenn vorhanden) schneller reagieren (d.h. mehr Reaktionsprodukt pro Zeit bilden) als zusammen mit dem Arbeitsgas (z.B. wenn es überhaupt mit dem Arbeitsgas chemisch reagiert). Das Reaktivgas und das Arbeitsgas können gemeinsam oder getrennt als Prozessgas (z.B. als Gasgemisch) zugeführt werden, beispielsweise mittels der Gaszuführvorrichtung.

Es kann verstanden werden, dass das hierin für das Sputtern Beschriebene in Analogie für jeden anderen Beschichtungsprozess, z.B. eine physikalische Gasphasenabscheidung, gelten kann, bei der das Targetmaterial bei Raumtemperatur als festes Material vorliegt. Beispielsweise weist die physikalische Gasphasenabscheidung (z.B. das Sputtern) auf, dass die chemische Zusammensetzung des Targets bzw. des Beschichtungsmaterials in die zu bildende Schicht übertragen wird. Bei Verwendung eines Reaktivgases kann eine Schicht, die das Reaktionsprodukt von Targetmaterial und Reaktivgas aufweist, gebildet werden.

Im Gegensatz zur CVD (**C**hemical **V**apor **D**eposition) wird bei der PVD (**P**hysical **V**apor **D**eposition), z.B. dem Sputtern, ein festes Material zunächst in die Gasphase (auch als gasförmige Phase oder Dampf bezeichnet) überführt und mittels dieser Gasphase eine Schicht gebildet. Die Gasphase des Targetmaterials kann bei der PVD optional (z.B. bei einer reaktiven PVD) chemisch reagiert werden (beispielsweise dann auch als reaktives PVD bzw. reaktives Sputtern bezeichnet) mit einem Reaktivgas zu einer chemischen Verbindung, welches in die Schicht eingebaut wird oder diese bildet. Bei der chemischen Reaktion der PVD werden somit zwei oder mehr Materialien zu der chemischen Verbindung zusammengeführt.

Mittels Sputterns wird beispielsweise eine teilkristalline bis amorphe Siliziumdünnschicht gebildet, die mittels eines anschließenden Hochtemperaturschritts zur Dotierung und/oder Kristallisation (sogenannte "solid phase crystallization") nachbehandelt wird.

Als Halbleiterübergang (auch als p-n-Übergang bezeichnet) kann eine Grenzfläche verstanden werden, an welcher sich zwei Halbleiter mit entgegengesetzter Dotierung berühren. An dem Halbleiterübergang wechselt die Dotierung beispielsweise von positiv (p) zu negativ (n).

Hierin wird Bezug genommen auf ein Verfahren und eine Vakuumanordnung (z.B. deren Vakuumsystem), die beispielsweise eingerichtet ist zum Durchführen des Verfahrens, im Zusammenhang mit dem Bearbeiten eines Solarzellenvorläufers (auch als Solarzellenpräkursor oder als teilprozessierte Solarzelle bezeichnet) als exemplarisches Substrat. Der Solarzellenvorläufer kann einen vorprozessierten Wafer aufweisen oder daraus bestehen. Alternativ oder zusätzlich kann der Solarzellenvorläufer einen Solarzellenschichtstapel (z.B. einen Halbleiterübergang aufweisend) aufweisen. Es kann verstanden werden, dass das für den Solarzellenvorläufer Beschriebene für jedes andere Substrat gelten kann, welches mit einen Halbleiter aufweist und/oder mit einem oder mehr als einem (z.B. amorphem) Halbleiter, vorzugsweise Silizium aufweisend, beschichtet ist. Bezüglich der Beschichtung und/oder bezüglich des Bearbeitens kann ferner verstanden werden, dass das für eine konkrete Seite (z.B. Rückseite oder Vorderseite) des Solarzellenvorläufer (bzw. Substrats) Beschriebene in Analogie gelten kann für die jeweils gegenüberliegende Seite (dann Vorderseite bzw. Rückseite) des Solarzellenvorläufers (bzw. Substrats).

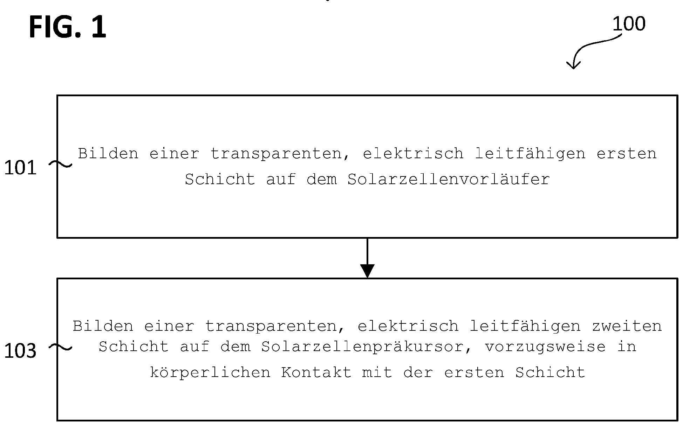

**Fig.1** veranschaulicht ein Verfahren 100 gemäß verschiedenen Ausführungsformen, beispielsweise gemäß einem der Beispiele 1 bis 25, in einem schematischen Ablaufdiagramm.

Das Bilden 101 der transparenten, elektrisch leitfähigen ersten Schicht (auch als erste TCO-Schicht bezeichnet) auf dem Solarzellenvorläufer und/oder das Bilden 103 der oder jeder transparenten, elektrisch leitfähigen zweiten Schicht (auch als zweite TCO-Schicht bezeichnet) auf dem Solarzellenvorläufer kann vorzugsweise im Vakuum erfolgen.

Die erste TCO-Schicht kann beispielsweise Indiumoxid (IO) als chemische Verbindung aus Indium und Sauerstoff aufweisen, wobei das Indiumoxid vorzugsweise mit Zinn als ersten Dotanten dotiert ist (dann auch als ITO bezeichnet). Es kann verstanden werden, dass alternativ oder zusätzlich zu Zinn auch Cer und/oder Wolfram als erster Dotant eingesetzt werden kann. Dies führt zu anderen elektrischen und optischen Eigenschaften, die vorteilhaft für die Solarzelleneigenschaften sein können.

Die erste TCO-Schicht kann beispielsweise Zinkoxid (ZnO) als chemische Verbindung aus Zink und Sauerstoff aufweisen, wobei das Zinkoxid vorzugsweise mit Aluminium als zweiten Dotanten dotiert ist (dann auch als AZO bezeichnet).

Beispielsweise kann die erste TCO-Schicht ein (z.B. homogenes) Gemisch aus Indiumoxid (z.B. ITO) und Zinkoxid (z.B. AZO) aufweisen und/oder einen Gradienten (d.h. ein graduelle Änderung) in dem Anteil von Indium oder von Zink, wobei der Gradient beispielsweise in Richtung zu der zweiten TCO-Schicht hin oder davon weg gerichtet ist.

Gemäß verschiedenen Ausführungsformen wird die erste TCO-Schicht als sogenannte Mischschicht bereitgestellt, die ein (z.B. homogenes) Gemisch von ITO und AZO aufweist oder daraus gebildet ist.

In einer ersten exemplarischen Implementierung der ersten TCO-Schicht kann deren Anteil Indium (auch als In-Anteil bezeichnet) in einem Bereich von ungefähr 5 bis ungefähr 95% sein und/oder einen Gradienten aufweisen in einem Bereich von ungefähr 1 at%/nm bis mindestens 30 at%/nm, z.B. ungefähr 4 at%/nm. Der Gradient kann beispielsweise in Richtung zu der zweiten TCO-Schicht hin oder davon weg gerichtet sein und/oder sich über einen Bereich von ungefähr 1 nm bis mindestens 15 nm in der ersten TCO-Schicht ausdehnen.

In der ersten oder einer zweiten exemplarischen Implementierung der ersten TCO-Schicht kann deren Anteil Zink (auch als Zn-Anteil bezeichnet) in einem Bereich von ungefähr 5 bis ungefähr 95% sein und/oder einen Gradienten aufweisen in einem Bereich von ungefähr 1 at%/nm bis mindestens 30 at%/nm, z.B. ungefähr 4 at%/nm. Der Gradient kann beispielsweise in Richtung zu der zweiten TCO-Schicht hin oder davon weg gerichtet sein und/oder sich über einen Bereich von ungefähr 1 nm bis mindestens 15 nm in der ersten TCO-Schicht ausdehnen.

In der ersten, zweiten oder einer zusätzlichen zweiten exemplarischen Implementierung der ersten TCO-Schicht kann deren Anteil Aluminium (auch als Al-Anteil bezeichnet) in einem Bereich von ungefähr 0 bis ungefähr 2% sein und/oder einen Gradienten aufweisen in einem Bereich von ungefähr 1 at%/nm bis mindestens 30 at%/nm, z.B. ungefähr 4 at%/nm. Alternativ oder zusätzlich kann ein Verhältnis von Aluminium zu Zink in der ersten TCO-Schicht auf einander gegenüberliegenden Seiten der ersten TCO-Schicht gleich eingerichtet sein. Der Gradient kann beispielsweise in Richtung zu der zweiten TCO-Schicht hin oder davon weg gerichtet sein und/oder sich über einen Bereich von ungefähr 1 nm bis mindestens 15 nm in der ersten TCO-Schicht ausdehnen.

In der ersten, zweiten, zusätzlichen zweiten oder einer vierten exemplarischen Implementierung der ersten TCO-Schicht kann deren Anteil Zinn (auch als Sn-Anteil bezeichnet) in einem Bereich von ungefähr 0at% bis ungefähr 10at% sein und/oder einen Gradienten aufweisen in einem Bereich von ungefähr 1 at%/nm bis mindestens 30 at%/nm, z.B. ungefähr 4 at%/nm. Alternativ oder zusätzlich kann ein Verhältnis von Zinn zu Indium in der ersten TCO-Schicht auf einander gegenüberliegenden Seiten der ersten TCO-Schicht gleich eingerichtet sein. Der Gradient kann beispielsweise in Richtung zu der zweiten TCO-Schicht hin oder davon weg gerichtet sein und/oder sich über einen Bereich von ungefähr 1 nm bis mindestens 15 nm in der ersten TCO-Schicht ausdehnen.

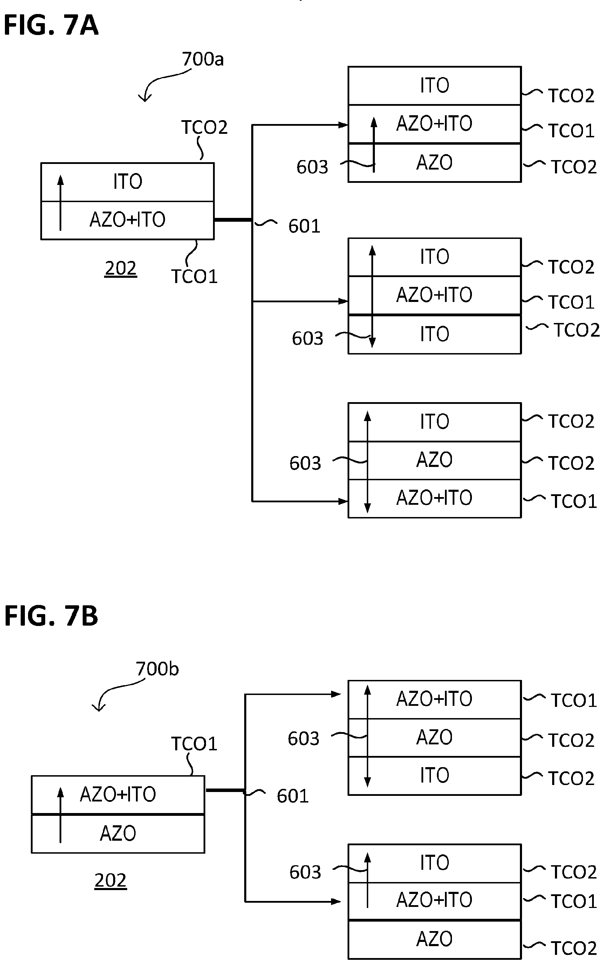

In einer ersten Konfiguration (siehe Fig.7A), beispielsweise wenn die erste TCO-Schicht als Vermittlerschicht und/oder eine zweite TCO-Schicht als Schutzschicht eingerichtet sind, kann die erste TCO-Schicht zwischen der zweiten TCO-Schicht und dem Solarzellenvorläufer angeordnet sein.

In einer zweiten Konfiguration (siehe Fig.7B), beispielsweise wenn die erste TCO-Schicht als Schutzschicht und/oder wenn eine zweite TCO-Schicht als Vermittlerschicht eingerichtet ist, kann die zweite TCO-Schicht zwischen der ersten TCO-Schicht und dem Solarzellenvorläufer angeordnet sein.

In einer exemplarischen Implementierung des Verfahrens 100 erfolgt eine Inline-Abscheidung von einem ITO-AZO-Schichtstapel in einem Vakuum (z.B. in einer Prozesskammer) mittels eines Doppel-Rohrmagnetrons oder zwei nebeneinander angeordneten Rohrmagnetrons. Zum Bilden des Schichtstapels werden wenigstens aufeinanderfolgend zwei TCO-Schichten (auch als erste und zweite TCO-Schicht bezeichnet) abgeschieden. Die erste der zwei TCO-Schichten weist Indium, Zink, Zinn, Aluminium und Sauerstoff auf. Die zweite der zwei TCO-Schichten weist Indium, Zinn und Sauerstoff auf oder Zink, Aluminium und Sauerstoff auf.

Die erste TCO-Schicht kann beispielsweise als Mischschicht aus ITO und AZO bereitgestellt sein oder werden. Alternativ oder zusätzlich kann die zweite TCO-Schicht entweder aus ITO oder aus AZO bestehen.

Gemäß verschiedenen Ausführungsformen wird somit ein inline-Beschichtungsverfahren 100 bereitgestellt zum Abscheiden eines transparenten und elektrisch leitfähigen Schichtstapels (auch als TCO-Schichtstapel bezeichnet), welcher mindestens zwei einander benachbarte (z.B. einander berührende) Schichten TCO1 und TCO2 aufweist. Die erste Schicht besteht aus mindestens den Elementen A, B und O. A und B stehen für zwei verschiedene Metalle oder Halbmetalle, wie beispielsweise In und Zn. O steht für Sauerstoff. Die Schicht TCO2 besteht aus mindestens den Elementen B und Sauerstoff.

Gemäß verschiedenen Ausführungsformen wird somit ein inline-Beschichtungsverfahren 100 bereitgestellt zum Abscheiden eines transparenten und elektrisch leitfähigen Schichtstapels, wobei der Schichtstapel mittels Sputterns von mindestens zwei keramischen Sputtertargets (kurz auch als Target bezeichnet) gebildet wird, wobei die zwei Targets eine sich in ihrer chemischen Zusammensetzung voneinander unterscheiden, nebeneinander angeordnet sind und in derselben Prozesskammer installiert sind, deren Dampfkeulen sich so überlappen, dass zwei benachbarte Schichten TCO1 und TCO2 gebildet werden. Vorzugsweise ist die Dicke der Schicht TCO1 größer beim Abscheiden der Schicht von zwei benachbarten Targets als von zwei Targets, die weiter räumlich voneinander getrennt sind und sich in zwei verschiedenen Prozesskammern angeordnet sind.

Optional kann der TCO-Schichtstapel, welcher die zwei einander benachbarten (z.B. einander berührenden) Schichten TCO1 und TCO2 aufweist, als Antireflexionsschicht eingerichtet sein. Dann kann der TCO-Schichtstapel, vorzugsweise bei einer Wellenlänge in einem Bereich von ungefähr 500 nm bis ungefähr 700 nm, einen Reflexionskoeffizienten von weniger als ungefähr 10% (z.B. als ungefähr 5% oder als ungefähr 1%) aufweisen. Dies wird erreicht, indem der Brechungsindex und die Schichtdicke des TCO-Schichtstapels eingestellt werden.

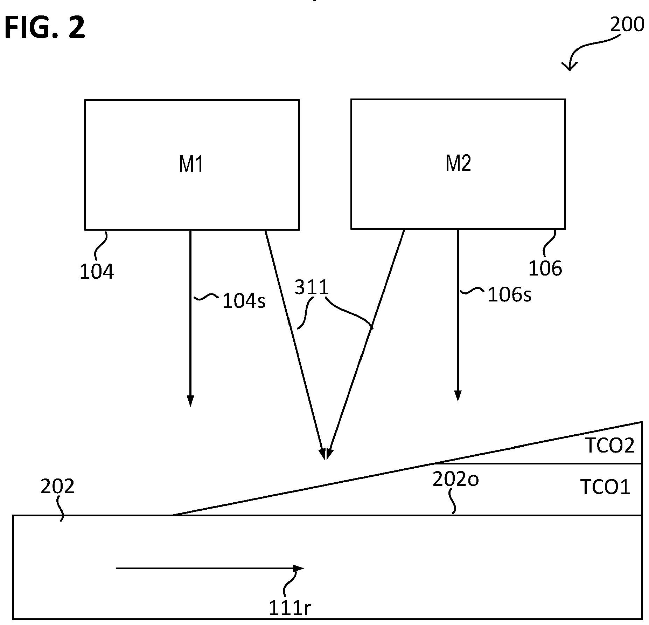

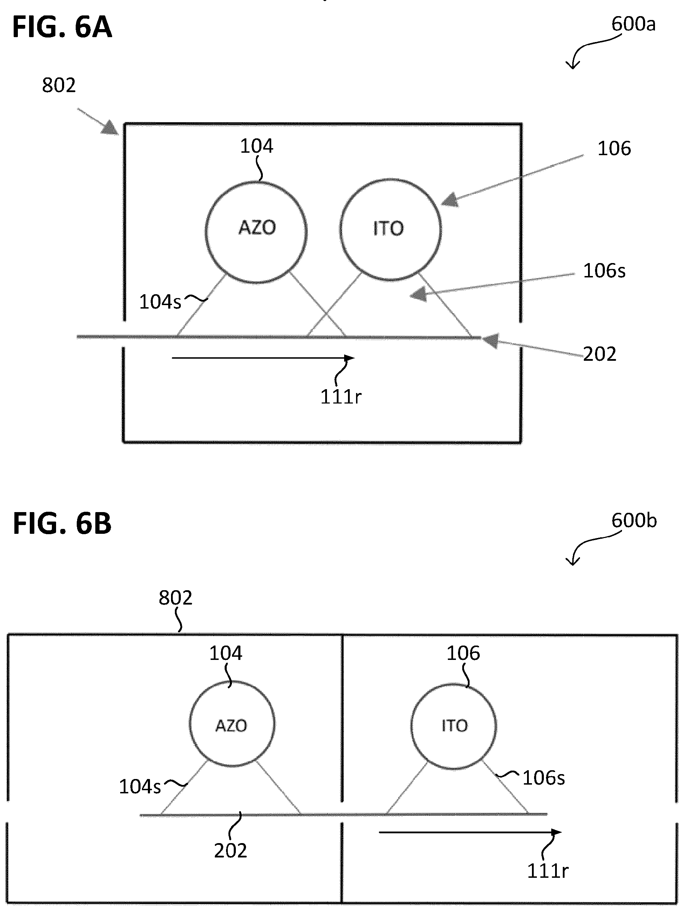

Der Solarzellenvorläufer kann beim Bilden der ersten TCO-Schicht und/oder der zweiten TCO-Schicht transportiert werden, z.B. entlang einer Transportrichtung 111r (siehe Fig.2) und/oder in einem Vakuum, das beispielsweise in einer Vakuumkammer 802 (siehe Fig.6A und 6B) bereitgestellt ist.

**Fig.2** veranschaulicht das Verfahren 100 gemäß verschiedenen Ausführungsformen 200, beispielsweise gemäß einem der Beispiele 1 bis 25, in einer schematischen Seitenansicht oder Querschnittsansicht, welche beispielsweise eingerichtet sind, die erste Konfiguration zu implementieren.

Der Solarzellenvorläufer 202 kann eine Seite 202o (auch als zu beschichtende Seite bezeichnet) aufweisen, die mit der ersten TCO-Schicht TCO1 beschichtet wird. Die zu beschichtende Seite kann beispielsweise eine Vorderseite oder eine Rückseite des Solarzellenvorläufers 202 sein. Auf der zu beschichtenden Seite 202o kann ein Halbleiter des Solarzellenvorläufers oder ein Oxid des Halbleiters freiliegen.

Das Bilden der ersten TCO-Schicht TCO1 kann mittels einer ersten Materialquelle 104 erfolgen, die eingerichtet ist, einen ersten Materialstrom 104s zu emittieren zu dem Solarzellenvorläufer 202. Die erste Materialquelle 104 kann ein erstes Targetmaterial M1 aufweisen oder daraus bestehen, z.B. in Form eines ersten Sputtertargets (z.B. AZO-Sputtertargets). Das erste Sputtertarget kann mittels eines Plasmas zerstäubt werden, um den ersten Materialstrom 104s zu emittieren. Das erste Targetmaterial M1 kann beispielsweise Zinkoxid aufweisen oder daraus bestehen, beispielsweise AZO.

Das Bilden der zweiten TCO-Schicht TCO2 kann mittels einer zweiten Materialquelle 106 erfolgen, die eingerichtet ist, einen zweiten Materialstrom 106s zu emittieren zu dem Solarzellenvorläufer 202. Die zweite Materialquelle 106 kann ein zweites Targetmaterial M2 aufweisen oder daraus bestehen z.B. in Form eines zweiten Sputtertargets (z.B. ITO-Sputtertargets). Das zweite Sputtertarget kann mittels eines Plasmas zerstäubt werden, um den zweiten Materialstrom 104s zu emittieren. Das zweite Targetmaterial M2 kann beispielsweise Indiumoxid (IO) aufweisen oder daraus bestehen, beispielsweise ITO.

Teile des zweiten Materialstroms 106s können zum Bilden der ersten TCO-Schicht TCO1 beitragen. Dazu können der erste Materialstrom 104s und der zweite Materialstrom 106s einander durchdringen. Anschaulich führt das Durchdringen zu einem homogenen Gemisch aus Indium, Zink und Sauerstoff, z.B. zu einem homogenen Gemisch aus Indiumoxid und Zinkoxid, z.B. zu einem homogenen Gemisch aus ITO und AZO. Die Vermischung verbessert die Beschichtungseigenschaften.

Dieses Durchdringen wird begünstigt, indem das erste Targetmaterial M1 und das zweite Targetmaterial M2 nahe beieinander angeordnet werden. Beispielsweise kann ein Abstand (auch als TT-Abstand bezeichnet) des ersten Targetmaterials M1 von dem zweiten Targetmaterial M2 kleiner sein als ein Abstand des Solarzellenvorläufers 202 von dem ersten Targetmaterial M1 und/oder dem zweiten Targetmaterials M2. Alternativ oder zusätzlich kann ein Abstand des ersten Targetmaterials M1 von dem zweiten Targetmaterial M2 kleiner sein als ungefähr 0,5 Meter, z.B. als ungefähr 0,3 Meter, z.B. als ungefähr 0,2 Meter, z.B. als ungefähr 0,1 Meter, z.B. als ungefähr 0,05 Meter. Dies begünstigt die Vermischung der Materialien. Im Falle von Rohrmagnetrons, welche die bevorzugten Beschichtungsquellen sind, kann der TT-Abstand der Abstand zwischen den Targetoberflächen der zwei nebeneinander angeordneten Rohrtargets sein.

Die erste TCO-Schicht TCO1 kann nahe dem Solarzellenvorläufer 202 einen größeren Anteil des ersten Targetmaterials M1 aufweisen als nahe der zweiten TCO-Schicht TCO2, d.h. dass deren Anteil des ersten Targetmaterials M1 in Richtung zu dem Solarzellenvorläufer 202 hin zunimmt. Alternativ oder zusätzlich kann die erste TCO-Schicht TCO1 nahe dem Solarzellenvorläufer 202 einen kleineren Anteil des zweiten Targetmaterials M2 aufweisen als nahe der zweiten TCO-Schicht TCO2 oder frei sein von dem zweiten Targetmaterial M2.

In einer exemplarischen Implementierung der Ausführungsformen 200 kann eine zweite TCO-Schicht TCO2 aus ITO auf der ersten TCO-Schicht TCO1, die ein zu der zweiten TCO-Schicht TCO2 hin zunehmendes Verhältnis aus ITO zu AZO aufweist, gebildet werden. Dies verlangsamt den Alterungsprozess der ersten TCO-Schicht TCO1 zu geringen Kosten.

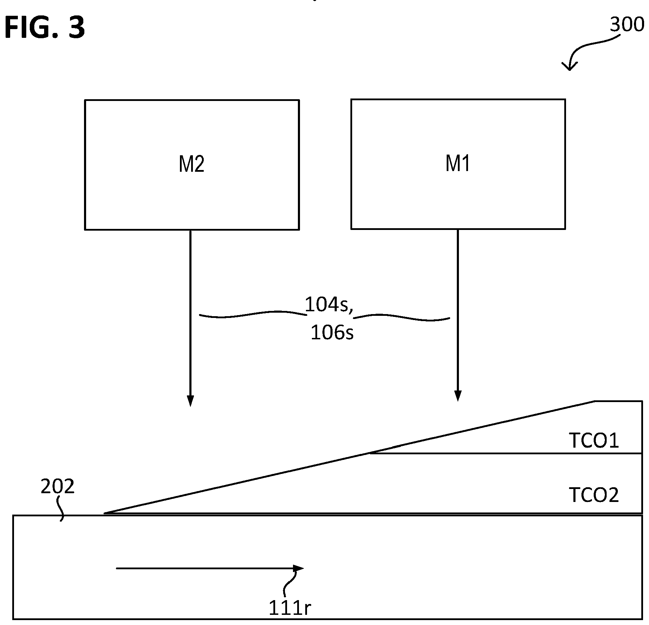

**Fig.3** veranschaulicht das Verfahren 100 gemäß verschiedenen Ausführungsformen 300, beispielsweise gemäß einem der Beispiele 1 bis 25, in einer schematischen Seitenansicht oder Querschnittsansicht. Gemäß den Ausführungsformen 300 kann, beispielsweise alternativ oder zusätzlich zu den Ausführungsformen 200, mittels des ersten Targetmaterials M1 beschichten werden, bevor mittels des zweiten Targetmaterials M2 beschichtet wird.

Teile 311 der zwei Materialströme 104s, 106s können zum Bilden der ersten TCO-Schicht TCO1 beitragen. Dazu können sich die zwei Materialströme einander durchdringen. Dies erleichtert das Verfahren.

Die erste TCO-Schicht TCO1 kann nahe dem Solarzellenvorläufer 202 einen größeren Anteil des ersten Targetmaterials M2 aufweisen als nahe der zweiten TCO-Schicht TCO2. Alternativ oder zusätzlich kann die erste TCO-Schicht TCO1 nahe dem Solarzellenvorläufer 202 einen kleineren Anteil des zweiten Targetmaterials M2 aufweisen als nahe der zweiten TCO-Schicht TCO2.

In einer exemplarischen Implementierung der Ausführungsformen 300 kann eine AZO-Schicht als zweite TCO-Schicht TCO2 unter der ersten TCO-Schicht TCO1 gebildet werden. Dies verringert die Kosten des Verfahrens weiter.

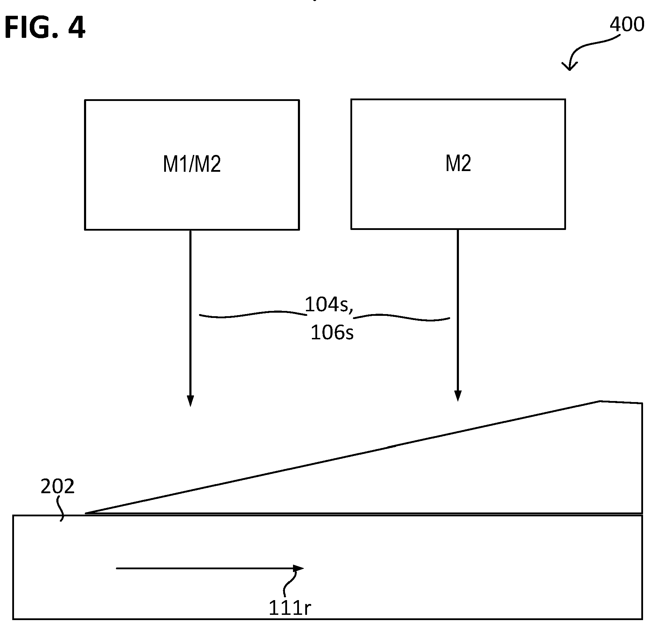

**Fig.4** veranschaulicht das Verfahren 100 gemäß verschiedenen Ausführungsformen 400, beispielsweise gemäß einem der Beispiele 1 bis 25, in einer schematischen Seitenansicht oder Querschnittsansicht, welche beispielsweise eingerichtet sind, die zweite Konfiguration zu implementieren.

Die Ausführungsformen 400 können aufweisen, dass der Solarzellenvorläufer 202 mit mehreren zweiten TCO-Schichten (TCO2) bedeckt ist, beispielsweise in körperlichem Kontakt miteinander oder zwischen diesen die erste TCO-Schicht (TCO1) angeordnet. Das Bilden jeder zweiten TCO-Schicht kann beispielsweise mittels des ersten Targetmaterials M1 oder des zweiten Targetmaterials M2 erfolgen. Im Verlauf des Beschichtens kann an zumindest einer Stelle ein Durchmischen des ersten Targetmaterials M2 und des ersten Targetmaterials M2 erfolgen, so dass der Solarzellenvorläufer 202 mit einem Materialgemisch beschichtet wird, welches transparent und elektrisch leitfähig ist und einen Anteil von Indium aufweist, der kontinuierlich zunimmt oder abnimmt entlang einer Richtung von dem Solarzellenvorläufer weg.

In einer exemplarischen Implementierung der Ausführungsformen 400 kann eine ITO-Schicht als zweite TCO-Schicht auf der ersten TCO-Schicht TCO1 gebildet werden. Dies verlangsamt den Alterungsprozess der Solarzelle, die nur mit der ersten TCO-Schicht TCO1 beschichtet wurde.

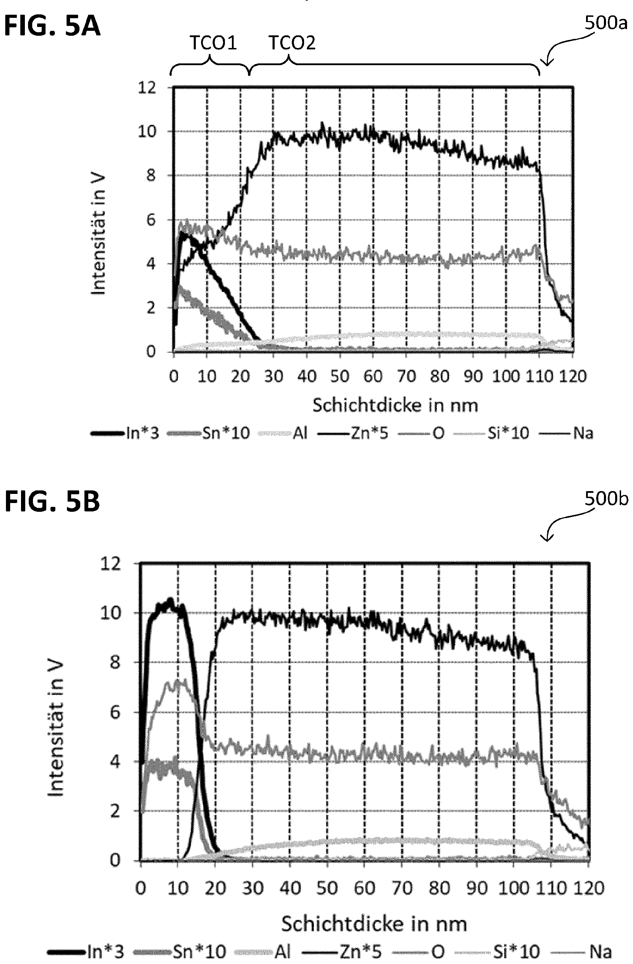

Fig.5A und B veranschaulichen jeweils ein Diagramm 500a und 500b, gemäß verschiedenen Ausführungsformen, beispielsweise gemäß einem der Beispiele 1 bis 25, in einer schematischen Ansicht. Veranschaulicht ist die räumliche Verteilung der chemischen Zusammensetzung von zwei exemplarischen Schichtstapeln zum Vergleich, die jeder gebildet wurden mittels zwei Sputtertargets, beispielsweise als Rohrkathoden ausgebildet, von denen ein Sputtertarget aus ITO (auch als ITO-Sputtertarget bezeichnet) und das andere Sputtertarget aus AZO (auch als AZO-Sputtertarget bezeichnet) bestand.

Diagramm 500a zeigt als ersten Fall, dass die zwei Sputtertarget derart nahe beieinander angeordnet sind, dass die zwei Materialströme aus ITO und AZO einander durchdringen. Diagramm 500b zeigt als zweiten Fall, dass die zwei Sputtertarget derart fern voneinander angeordnet sind, dass die zwei Materialströme aus ITO und AZO voneinander separiert (z.B. gassepariert) sind. Beispielsweise können die zwei Sputtertarget im zweiten Fall in voneinander gasseparierten Prozessierkammern angeordnet sein.

Gemessen wurde die optische Emission der chemischen Elemente des Schichtstapels mittels optischer Glimmentladungsspektroskopie (GD-OES). Bei der Glimmentladungsspektroskopie wird mittels Ionenbeschusses einer Glimmentladung die zu untersuchende Beschichtung (z.B. der Schichtstapel) abgetragen. Die dabei abgetragenen Elemente der Beschichtung werden durch die Glimmentladung angeregt und emittieren eine elementspezifische, charakteristische Strahlung, die zeitaufgelöst gemessen wird. Die Zeit ist dabei ein Maß für den Ort der Messung, der sich im Zeitverlauf in die Beschichtung hinein bewegt, was in diesem Fall ein Maß für den Ort entlang der Schichtdicke ist. Die Intensität der charakteristischen Strahlung eines Elements ist ein Maß für die Menge des Elements in dem Schichtstapel. Umso höher die Intensität des Elementes ist, umso höher ist sein Anteil (z.B. Konzentration) in dem Schichtstapel.

In den Diagrammen 500a und 500b ist jeweils die optische Intensität für jedes der Elemente Indium, Zinn, Aluminium, Zink, Sauerstoff, Silizium und Natrium aufgetragen, in Abhängigkeit des Orts entlang der Schichtdicke der Beschichtung, welche die erste TCO-Schicht und die zweite TCO-Schicht aufweist.

Die Beschichtung aus Diagramm 500b wurde gebildet, indem in einer ersten Prozesskammer ungefähr 85 nm (Nanometer) AZO auf ein Glassubstrat abgeschieden wurde. Unmittelbar darauf wurde in einer zweiten, von der ersten Prozessierkammer gasseparierten, zweiten Prozesskammer ungefähr 20 nm ITO auf dem AZO abgeschieden. Die zwei Materialströme (anschaulich auch als Dampfkeulen bezeichnet) des AZO- und des ITO-Sputterprozesses weisen aufgrund der Abscheidung in voneinander gasseparierten Prozesskammern keine Durchdringung (Überlappung) auf. Dennoch zeigt das Diagramm 500b zwischen 12 und 22 nm einen Anstieg der Zink-Intensität und einen Abfall der Indium-Intensität und damit derer Konzentrationen.

Diese Überlagerung von Indium und Zink in einem Bereich der Schichtdicke, in dem exemplarischen Fall hier zwischen 12 und 22 nm, ist zwar ein Anzeichen dafür, dass eine Mischschicht gebildet worden sein könnte, die Indium, Zink und Sauerstoff aufweist. Zu beachten ist allerdings die räumliche Auflösungsgrenze des Messverfahrens, welches eine Oberfläche mit dem Durchmesser von ungefähr 4 mm abträgt. Ferner wird der Schichtstapel durch die Glimmentladung nicht perfekt homogen abgetragen. Es entstehen Vertiefungen, sogenannte Sputtergräben, die dazu führen können, dass trotz einer scharfen Grenzfläche zwischen zwei Schichten, zum selben Zeitpunkt sowohl Intensitäten der Elemente der einen als auch der anderen Schicht gemessen werden können. Dasselbe gilt für die Rauheit der Grenzfläche.

Dies lässt sich gut vergleichen mit der Grenzfläche zwischen Glas und AZO im Bereich zwischen 102 und 120 nm im Diagramm 500b. Dort wird sowohl die optische Emission von Silizium als auch von Zink gemessen, obwohl zwischen Glas und der AZO-Schicht eine scharfe Grenzfläche existiert.

Wird der Intensitätsverlauf von diesen Einflüssen bereinigt, entsteht ein abrupter, sehr steiler Abfall der Indium-Intensität und ein abrupter, sehr steiler Anstieg der Zink-Intensität bei 20 nm, der aus der räumlichen Trennung des AZO- und ITO-Sputterprozesses voneinander resultiert. Die Ursache für den nicht abrupten Anstieg bzw. Abfall der Intensitäten von Zink und Indium ist somit im Messverfahren begründet.

Der Schichtstapel aus Diagramm 500a wurde gebildet mittels Sputterns von den zwei nahe beieinander angeordneten Sputtertargets (z.B. Rohrkathoden) in derselben Prozesskammer, beispielsweise von einem Doppelrohrmagnetron. Diese Nähe der Rohrkathoden begünstigt, dass sich deren Dampfkeulen überlappen, d.h. einander durchdringen und dabei vermischen. Beispielsweise kann ein Abstand der Targetoberflächen der zwei Sputtertargets voneinander kleiner sein als ein Abstand des Solarzellenvorläufers 202 zu den Targetoberflächen. Alternativ oder zusätzlich kann ein Abstand der zwei Targetoberflächen der Sputtertargets voneinander kleiner sein als ungefähr 0,5 Meter, z.B. als ungefähr 0,3 Meter, z.B. als ungefähr 0,2 Meter, z.B. als ungefähr 0,1 Meter, z.B. als ungefähr 0,05 Meter. Dies begünstigt die Vermischung der Materialien.

Die Beschichtungsrate des AZO-Sputtertargets war für eine AZO-Schichtdicke von 20 nm und die des ITO-Sputtertargets für eine ITO-Schichtdicke von 90 nm experimentell und jeweils separat auf Glas ermittelt und somit justiert worden. Diagramm 500a zeigt zwischen 0 und 25 nm das Vorhandensein sowohl Indium als auch Zink. Der Bereich, in dem Intensitäten von Zink und Indium gleichzeitig gemessen werden, ist mit 25 nm deutlich größer als der Bereich von ungefähr 10 nm, der in Diagramm 500b gezeigt ist.

Diese Daten zeigen, dass das Durchdringen der Materialströme das Bilden eines Gemisches begünstigt, mit dem der Solarzellenvorläufer beschichtet wird, wobei das Gemisch Indium, Zink und Sauerstoff aufweist, und vorzugsweise ferner einen ersten Dotanten der chemischen Verbindung aus Indium und Sauerstoff und/oder einen zweiten Dotanten der chemischen Verbindung aus Zink und Sauerstoff aufweist.

Die Durchmischung der Materialströme (z.B. von ITO und AZO) von zwei Sputtertargets kann beeinflusst werden mittels der nachfolgenden Parameter:
- Grad der Durchdringung der Materialströme;
- Abstand der zwei Targetmaterialien (z.B. Sputtertargets) voneinander;
- Ausrichtung der Magnetfelder, von denen die zwei Targetmaterialien (z.B. Sputtertargets) durchdrungen werden;
- räumliche Verteilung des Plasmas, mittels welchem die zwei Targetmaterialien (z.B. Sputtertargets) zerstäubt werden;
- eine physische Gasseparation zwischen den zwei Targetmaterialien (z.B. eine Trennwand oder eine Gasseparationskammer).

Die Entstehung der Mischschicht kann beispielsweise gehemmt werden,
- wenn die Prozesskammern in der Transportrichtung verlängert werden und damit der Abstand der beiden Sputtertargets vergrößert wird;
- wenn die Magnetfelder der beiden Sputtertargets nach außen zur Kammerwand ausgerichtet werden;
- wenn eine Trennwand bis zum Substrat zwischen den beiden Sputtertargets eingebaut wird;
- mittels Einbaus zusätzlicher Prozess- oder Gasseparationskammern in die Sputteranlage, um die Schichtabscheidung hinreichend räumlich zu trennen.

Die kann aber die Kosten für eine Sputteranlage mit verlängerten Sputterkammern vergrößern. Auch die Anlagenlänge wird größer, was oft nicht gewünscht ist. Die Separation kann die Dampfausnutzung des abgesputterten Materials verringern und damit auch die Rate, da auf die Kammerwände und die Trennwand gesputtert wird. Das erhöht die Beschichtungskosten.

Gemäß verschiedenen Ausführungsformen lassen sich ausgelieferte Sputteranlagen oder auch gerade verkaufte Sputteranlagen kostengünstig umrüsten, um ITO- und AZO-Schichten abzuscheiden, beispielsweise ohne diese erweitern zu müssen. Durch den Einsatz kostengünstigerer AZO-Targets werden erhebliche Targetkosten eingespart. Es kann ein Schichtstapel mit einer oder mehr als einer Mischschicht aus zwei verschiedenen TCOs, z.B. ITO und AZO, in derselben Vakuumkammer (auch als Vakuum-Prozessierkammer oder Prozessierkammer bezeichnet) gesputtert werden. Die erleichtert es, die Solarzelleneigenschaften noch weiter zu verbessern. Die Sputteranlage kann kostengünstiger hergestellt werden, da weniger Prozesskammern oder schmalere Prozesskammern eingesetzt werden können. Die Mischschicht begünstigt ferner die Haftung und Damp-Heat-Stabilität des TCO-Schichtstapels.

**Fig.6A** und B veranschaulichen jeweils eine Vakuumanordnung 600a und 600b, gemäß verschiedenen Ausführungsformen, beispielsweise gemäß einem der Beispiele 1 bis 25, in einer schematischen Seitenansicht oder Querschnittsansicht. Die Vakuumanordnung 600a und 600b weist die Vakuumkammer 802 und eine Transportvorrichtung (nicht dargestellt) zum Transportieren des Solarzellenvorläufer 202 in der Vakuumkammer 802 entlang der Transportrichtung 111r auf.

In der nachfolgenden Tabelle werden Eigenschaften von zwei Vergleichsbeispielen wiedergegeben, von denen der erste TCO-Schichtstapel AZO/ITO (220303#11) in zwei separaten Prozesskammern 802 abgeschieden wurde (Fall 2, siehe Vakuumanordnung 600b) und der zweite Schichtstapel (220223#5) in genau einer Prozessierkammer 802 abgeschieden wurde (Fall 1, siehe Vakuumanordnung 600a), z.B. mittels zwei nah beieinander angeordneten Rohrmagnetrons. Eines der Rohrmagnetrons weist ein keramisches AZO-Target und das andere Rohrmagnetron ein keramisches ITO-Rohrtarget auf.

| Probe | 220223#5 | 220303#11 |
|---|---|---|
| AZO Sauerstoff [%] | 2,0 | 1,5 |
| ITO Sauerstoff [%] | | 2,6 |
| Schichtdicke [nm] | 110 | 106 |
| Flächenwiderstand [Ohm] | 326 | 348 |
| Spezifischer Widerstand [µOhmcm] | 3580 | 3696 |
| Transmission gemittelt zwischen 400 und 1100 nm [%] | 82,6 | 82,6 |

Die Prozessparameter zum Bilden des TCO-Schichtstapels 220303#11 wurde dabei derart angepasst, dass dessen Beschichtungseigenschaften möglichst wenig Unterschied zu den Beschichtungseigenschaften des TCO-Schichtstapels 220223#5 aufweisen. Wie zu sehen ist, weisen die Prozessparameter zum Bilden des TCO-Schichtstapels 220303#11 unterschiedliche Sauerstoffgehalte im Prozessgas beider Prozessierkammern auf, was die Herstellung erschwert.

Demgegenüber kann das Bilden des TCO-Schichtstapels 220223#5 demselben Gasdruck und/oder derselben chemischen Zusammensetzung des Prozessgases ausgesetzt sein, ohne eine Beeinträchtigung der Beschichtungseigenschaften in Kauf nehmen zu müssen. Dies erleichtert die Herstellung. Allgemeiner gesprochen lässt sich diesen Daten entnehmen, dass die Vermischung von Indium, Zink und Sauerstoff (z.B. von ITO und AZO) die Beschichtungseigenschaften verbessert und somit ungünstigere Herstellungsbedingungen kompensiert.

**Fig.7A** und B veranschaulichen jeweils die Beschichtung des Solarzellenvorläufers in verschiedenen Konfigurationen. Dargestellt ist links die Basiskonfiguration 700a und 700b der Beschichtung, welche die erste TCO-Schicht TCO1 und eine zweite TCO-Schicht TCO2 aufweist, und rechts eine Abwandlung 601 der Basiskonfiguration 700a und 700b, indem der Beschichtung eine zusätzliche zweite TCO-Schicht TCO2 hinzugefügt wird. Zwei zweite TCO-Schichten TCO2 können beispielsweise entweder einander berühren oder jede die erste TCO-Schicht TCO1 berühren. Zwei zweite TCO-Schichten TCO2 können sich voneinander unterscheiden in ihrer chemischen Zusammensetzung, beispielsweise in dem Anteil Zink oder Indium. Jede zweite TCO-Schicht TCO2 kann beispielsweise entweder aus AZO oder aus ITO bestehen.

Der Pfeil 603 gibt jeweils die Richtung (z.B. Richtung der Schichtdicke) an, in welche die Konzentration von Indium zunimmt.

Eine exemplarische Implementierung der Abwandlung 601 der Basiskonfiguration 700b weist zwei zweite TCO-Schichten TCO2 auf, zwischen denen die erste TCO-Schicht TCO1 angeordnet ist, beispielsweise in körperlichem Kontakt mit einer oder mehr als einer der zwei zweiten TCO-Schichten TCO2. Beispielsweise kann die erste TCO-Schicht TCO1 zumindest Indium und Sauerstoff (z.B. eine chemische Verbindung daraus) und optional Zink, Zinn und/oder Aluminium aufweisen oder daraus bestehen, beispielsweise ein Gemisch aus ITO und AZO. Alternativ oder zusätzlich kann eine oder mehr als eine der zwei zweiten TCO-Schichten TCO2 Indium und Sauerstoff (z.B. eine chemische Verbindung daraus, beispielsweise ITO) und optional Zink aufweisen oder daraus bestehen und/oder eine kleinere Schichtdicke als die erste TCO-Schicht TCO1 aufweisen.

Beispielsweise kann eine der zwei zweiten TCO-Schichten TCO2 (z.B. aus ITO bestehend) in körperlichem Kontakt mit dem Substrat (z.B. dessen Halbleitermaterial) und/oder mit der ersten TCO-Schicht TCO1 (z.B. aus dem Gemisch aus ITO und AZO bestehend) sein. Dies verbessert die Haftung der ersten TCO-Schicht TCO1 an dem Substrat (z.B. dessen Halbleitermaterial). Alternativ oder zusätzlich kann die erste TCO-Schicht TCO1 (z.B. aus dem Gemisch aus ITO und AZO bestehend) zwischen den zwei zweiten TCO-Schichten TCO2 (z.B. aus ITO bestehend) angeordnet und/oder in körperlichem Kontakt mit diesen sein. Dies verbessert die Haftung an dem Substrat und die Lebensdauer der ersten TCO-Schicht TCO1.

Alternativ oder zusätzlich kann die erste TCO-Schicht TCO1 nahe dem Solarzellenvorläufer 202 einen kleineren Anteil des zweiten Targetmaterials M2 aufweisen als nahe der zweiten TCO-Schicht TCO2 oder frei sein von dem zweiten Targetmaterial M2, das beispielsweise Indiumoxid (IO), beispielsweise ITO, aufweisen oder daraus bestehen kann.

Eine exemplarische Implementierung eines Verfahrens 100, mittels welchem eine Abwandlung 601 der Basiskonfigurationen 700a, 700b gebildet wird, wird mittels vier entlang der Transportrichtung des Substrats hintereinander angeordneten Targets (z.B. mittels zwei Doppel-Rohrmagnetrons bereitgestellt) durchgeführt, von denen zumindest zwei (z.B. einander unmittelbar gegenüberliegende) Targets sich voneinander unterscheiden (z.B. in ihrer chemischen Zusammensetzung und/oder ihrer Zerstäubungsrate) und/oder von denen zwei oder drei Targets übereinstimmen (z.B. in der chemischen Zusammensetzung und/oder Zerstäubungsrate).

Von den vier Targets können beispielsweise ein erstes Target und/oder ein zweites Target das zweite Targetmaterial M2 aufweisen. Alternativ oder zusätzlich kann von den vier Targets können ein oder mehr als ein zwischen dem ersten und dem zweiten Target angeordnetes Target das erste Targetmaterial M1 aufweisen.

Je größer die Rate, mit der ein Target zerstäubt wird (auch als Zerstäubungsrate bezeichnet), ist, desto größer kann die Rate sein, mit der das Bilden eine Schicht erfolgt (auch als Beschichtungsrate bezeichnet). Bezogen auf das Bilden einer Schicht, ist die resultierende Schichtdicke der Schicht eine Funktion der Zerstäubungsrate und der Dauer des Bildens der Schicht (auch als Beschichtungsdauer bezeichnet). Wird das Substrat mit einer konstanten Transportgeschwindigkeit transportiert, ist die Beschichtungsdauer eine Funktion der Anzahl an Targets, welche mit der Zerstäubungsrate zerstäubt werden und in der Regel entlang der Transportrichtung hintereinander angeordnet sind. Basierend darauf lässt sich die Materialmenge eines Materials (z.B. einer chemischen Verbindung, welche optional dotiert sein kann, z.B. AZO) in einem Schichtstapel, der einen oder mehr als einen erste TCO-Schicht TCO1 und eine oder mehr als eine zweite Schicht TCO2 aufweist, ebenso angeben als Dicke einer Schicht (auch als Schichtdickenäquivalent bezeichnet), die entstehen würde, wenn diese aus der Materialmenge des Materials bestehen würde. Das Schichtdickenäquivalent erlaubt es, die Zusammensetzung von Schichtstapeln besser vergleichen zu lassen, auch wenn die Materialien teilweise vermischt werden.

Dies wird an einem exemplarischen Schichtstapel erläutert, der die erste TCO-Schicht TCO1 (aus dem Gemisch aus ITO und AZO bestehend) zwischen den zwei zweiten TCO-Schichten TCO2 (aus ITO bestehend) aufweist (auch als ITO/ITO+AZO/ITO-Stapel bezeichnet). Der ITO/ITO+AZO/ITO-Stapel kann beispielsweise ein Schichtdickenäquivalent dazo von AZO aufweisen, das zwischen zwei voneinander separierten Schichtdickenäquivalenten d_{ITO} von ITO angeordnet ist. Das Schichtdickenäquivalent dazo kann beispielsweise in einem Bereich von ungefähr 30 nm bis ungefähr 100 nm sein, z.B. 70 nm, und/oder größer sein als das Schichtdickenäquivalent d_{ITO}. Alternativ oder zusätzlich kann das Schichtdickenäquivalent d_{ITO} beispielsweise in einem Bereich von ungefähr 5 nm bis ungefähr 30 nm sein, z.B. 15 nm.

Soll die Menge an AZO in dem Schichtstapel, der beispielsweise die erste TCO-Schicht TCO1 (z.B. aus dem Gemisch aus ITO und AZO bestehend) zwischen den zwei zweiten TCO-Schichten TCO2 (z.B. aus ITO bestehend) aufweist, vergrößert werden, kann dies erreicht werden, indem die Anzahl von Targets aus AZO und/oder die elektrische Leistung, die das Plasma umsetzt, mittels welchem AZO zerstäubt wird, vergrößert werden.

Beispielsweise kann der ITO/ITO+AZO/ITO-Stapel gebildet werden mittels zwei Doppel-Rohrmagnetrons, zwischen denen optional eine Kammerwand (z.B. eine Kompartment-Trennwand) angeordnet ist und von denen jedes Doppel-Rohrmagnetron zwei Targets aufweist. Die zwei Doppel-Rohrmagnetrons können eine Anzahl k_{AZO} von Targets aus AZO und eine Anzahl k_{ITO} von Targets aus ITO aufweisen, wobei k_{AZO}=1 oder k_{AZO}=2 ist und k_{ITO} = 4 - k_{AZO} ist. Jedes der Targets aus AZO kann zwischen zwei der Targets aus ITO angeordnet sein und eingerichtet sein, zusammen mit zumindest einem der Targets aus ITO das Gemisch aus ITO und AZO zu bilden, z.B. indem die von diesen Targets emittierten Materialströme einander durchdringen. Beispielsweise kann nur eines oder jedes der zwei Doppel-Rohrmagnetrons ein Target aus ITO und ein Target aus AZO aufweisen, deren emittierte Materialströme einander durchdringen, beispielsweise gemäß folgender Reihenfolge angeordnet: ITO/AZO-AZO/ITO oder ITO/ITO-AZO/ITO oder ITO/AZO-ITO/ITO. Die zwei Doppel-Rohrmagnetrons können optional derselben chemischen Zusammensetzung des Prozessgases (z.B. molekularen Sauerstoff aufweisend oder daraus gebildet) und/oder demselben Prozessgasdruck ausgesetzt sein. Beispielsweise können zwei Rohrtargets pro Kompartment einer Vakuumkammer verwendet werden, die in dem Kompartment angeordnet sind und/oder molekularem Sauerstoff als Prozessgas ausgesetzt sind.

Es kann verstanden werden, dass das hierin exemplarisch für AZO Beschriebene in Analogie gelten kann für das erste Targetmaterial M1 im Allgemeinen und/oder das hierin exemplarisch für ITO Beschriebene in Analogie gelten kann für das zweite Targetmaterial M2 im Allgemeinen.

Je größer der Anteil Indium (oder eine chemische Verbindung, z.B. Oxid, daraus, z.B. InO) des Schichtstapels an der Grenzfläche zu dem Substrat (z.B. dessen Halbleitermaterial) ist, desto besser haftet der Schichtstapel an dem Substrat. Weist der Schichtstapel ein Gemisch aus ITO und ATO auf, das in Kontakt mit dem Substrat (z.B. dessen Halbleitermaterial) ist, dann ist die Haftung zwischen diesen besser, je größer das Verhältnis zwischen Indium und Zinn in dem Gemisch ist. Beispielsweise wird die Haftung wesentlich verbessert, wenn mehr Indium (oder eine chemische Verbindung, z.B. Oxid, daraus, z.B. InO) als Zink (oder eine chemische Verbindung, z.B. Oxid, daraus, z.B. ZnO) in Kontakt mit dem Substrat (z.B. dessen Halbleitermaterial) ist.

## Patentansprüche

1. Verfahren (100) zum Prozessieren einer Solarzellenvorstufe (202), das Verfahren (100) aufweisend:
• Bilden einer transparenten, elektrisch leitfähigen ersten Schicht (TCO1) über der Solarzellenvorstufe (202), vorzugsweise wenn die Solarzellenvorstufe transportiert wird;
• Bilden zumindest einer transparenten, elektrisch leitfähigen zweiten Schicht (TCO2) über der Solarzellenvorstufe (202), vorzugsweise in körperlichem Kontakt mit der ersten Schicht (TCO1) und/oder wenn die Solarzellenvorstufe transportiert wird, wovon eine zweite Schicht (TCO2) zwischen dem Substrat und der ersten Schicht (TCO1) angeordnet ist und mehr Indium als Zink aufweist;
• wobei die erste Schicht (TCO1) zumindest Indium, Zink und Sauerstoff aufweist;
• wobei die zweite Schicht (TCO2) Sauerstoff und einen größeren Anteil von Indium als die erste Schicht (TCO1) aufweist.

2. Verfahren (100) gemäß Anspruch 1, wobei ein erster Materialstrom zum Bilden der ersten Schicht (TCO1) und ein zweiter Materialstrom zum Bilden der zweiten Schicht (TCO2) einander durchdringen und/oder demselben Prozessgas ausgesetzt sind.

3. Verfahren (100) gemäß Anspruch 1 oder 2, wobei die zweite Schicht (TCO2) in körperlichen Kontakt ist mit einem Halbleiter der Solarzellenvorstufe (202) und/oder einem Oxid des Halbleiters.

4. Verfahren (100) gemäß einem der Ansprüche 1 bis 3, wobei ein Stapel, der die erste Schicht (TCO1) und die zumindest eine zweite Schicht (TCO2) aufweist, vorzugsweise bei einer Wellenlänge von 600 nm, einen Reflexionskoeffizienten von weniger als 10% aufweist.

5. Verfahren (100) gemäß einem der Ansprüche 1 bis 4, wobei die erste Schicht (TCO1) eine größere Schichtdicke aufweist als die zweite Schicht (TCO2).

6. Verfahren (100) gemäß einem der Ansprüche 1 bis 5, wobei die zweite Schicht (TCO2) einen Dotanten einer chemischen Verbindung aus Indium mit Sauerstoff aufweist, wobei der Dotant vorzugsweise Zinn und/oder Zirkon und/oder Titan und/oder Cer und/oder Wolfram aufweist.

7. Verfahren (100) gemäß einem der Ansprüche 1 bis 6, wobei die zweite Schicht (TCO2) mehr als doppelt so viel Indium wie Zink aufweist und/oder mindestens 10 nm dick ist.

8. Verfahren (100) gemäß einem der Ansprüche 1 bis 7,
• wobei das Bilden der ersten Schicht (TCO1) mittels Zerstäubens eines ersten, vorzugsweise keramischen, Sputtertargets erfolgt, und
• wobei das Bilden der zweiten Schicht (TCO2) mittels Zerstäubens eines zweiten, vorzugsweise keramischen, Sputtertargets erfolgt.

9. Verfahren (100) gemäß einem der Ansprüche 1 bis 8, wobei die zumindest eine zweite Schicht (TCO2) die zweite Schicht (TCO2) und eine zusätzliche zweite Schicht (TCO2) aufweist, zwischen denen die erste Schicht (TCO1) angeordnet ist.

10. Verfahren (100) gemäß Anspruch 9, wobei die erste Schicht (TCO1) eine größere Dicke aufweist als die zusätzliche zweite Schicht.

11. Verfahren (100) zum Prozessieren einer Solarzellenvorstufe (202), das Verfahren (100) aufweisend:
• Emittieren eines ersten Materialstroms, der Zink und Sauerstoff aufweist, zu der Solarzellenvorstufe (202) hin;
• Emittieren eines zweiten Materialstroms, der Indium und Sauerstoff aufweist, zu der Solarzellenvorstufe (202) hin;
• wobei das Emittieren des ersten Materialstroms und das Emittieren des zweiten Materialstroms derart erfolgt,
dass dadurch ein Materialgemisch gebildet wird,
• mit welchem die Solarzellenvorstufe (202) beschichtet wird und mehr Indium als Zink aufweist,
• welches transparent und elektrisch leitfähig ist, und
• welches einen Anteil von Indium aufweist, der abnimmt entlang einer Richtung von der Solarzellenvorstufe (202) weg.

12. Solarzelle, aufweisend:
• einen Halbleiter;
• eine transparente, elektrisch leitfähige erste Schicht (TCO1) über dem Halbleiter;
• eine oder mehr als eine transparente, elektrisch leitfähige zweite Schicht (TCO1) über dem Halbleiter, wovon eine zweite Schicht (TCO2) zwischen dem Halbleiter und der ersten Schicht (TCO1) angeordnet ist und mehr Indium als Zink aufweist;
• wobei die erste Schicht (TCO1) Indium, Zink und Sauerstoff aufweist;
• wobei die zweite Schicht (TCO2) Sauerstoff und einen größeren Anteil von Indium als die erste Schicht (TCO1) aufweist.
